# FASCICULE DE BREVET EUROPEEN

(11) **EP 4 498 104 B1**
(45) Date de publication et mention de la délivrance du brevet: **13.05.2026**
(21) Numéro de dépôt: 24191038.9
(22) Date de dépôt: 26.07.2024
(51) Int. Cl.: G01R 31/367, G01R 31/392, H01M 10/48

(54) **PROCÉDÉ ET SYSTÈME DE PRÉDICTION DE L'ÉTAT DE DÉGRADATION D'UNE BATTERIE ÉLECTRIQUE**
VERFAHREN UND SYSTEM ZUR VORHERSAGE DES DEGRADATIONSZUSTANDS EINER ELEKTRISCHEN BATTERIE
METHOD AND SYSTEM FOR PREDICTING DEGRADATION STATE OF ELECTRIC BATTERY

(30) Priorité: 28.07.2023 FR 2308221
(43) Date de publication de la demande: 29.01.2025
(73) Titulaire: Centre National de la Recherche Scientifique, 75016 Paris (FR); Renault s.a.s, 92100 Boulogne Billancourt (FR); Université Amiens Picardie Jules Verne, 80090 Amiens (FR)
(72) Inventeur: ASCH, Mark, 80039 AMIENS (FR); ATI, Mohamed, 78280 GUYANCOURT (FR); EL-MALKI, Amina, 80039 AMIENS (FR); FRANCO, Alejandro, 80039 AMIENS (FR)
(74) Mandataire: Yes My Patent

(56) Documents cités:
- WO-A1-2022/229611
- CN-A- 114 578 237
- US-A1- 2019 113 577
- US-B2- 10 935 608
- FEI ZICHENG ET AL: "Early prediction of battery lifetime via a machine learning based framework", ENERGY, ELSEVIER, AMSTERDAM, NL, vol. 225, 27 February 2021 (2021-02-27), XP086551128, ISSN: 0360-5442, [retrieved on 20210227], DOI: 10.1016/J.ENERGY.2021.120205
- YOU GAE-WON ET AL: "Real-time state-of-health estimation for electric vehicle batteries: A data-driven approach", APPLIED ENERGY, ELSEVIER SCIENCE PUBLISHERS, GB, vol. 176, 14 May 2016 (2016-05-14), pages 92 - 103, XP029570645, ISSN: 0306-2619, DOI: 10.1016/J.APENERGY.2016.05.051

## Description

### DOMAINE TECHNIQUE

La présente invention concerne le domaine des batteries électriques. Elle trouve pour application particulièrement avantageuse le domaine de la prédiction de l'état de dégradation d'une batterie électrique.

### ETAT DE LA TECHNIQUE

Le développement de batteries électriques, tel que les batteries lithium-ion hautes performances, est un domaine de recherche crucial, en particulier dans le contexte des véhicules électriques (VE) où la longévité et l'efficacité de la batterie ont un impact direct sur l'autonomie et les performances globales du véhicule. Cependant, le vieillissement de la batterie électrique, et en particulier des batteries lithium-ion (LiB), est un processus complexe qui peut avoir un impact significatif sur les performances et la durée de vie de la batterie, ce qui en fait une considération importante dans la conception et le fonctionnement des LiB.

Le processus de vieillissement des LiB est influencé par plusieurs facteurs, notamment les protocoles de cyclage et les conditions de stockage. Il est donc difficile de prédire avec précision le processus de vieillissement et de développer des stratégies efficaces pour l'atténuer. Les études expérimentales sur le vieillissement des LiB sont généralement très longues et très coûteuses.

Un objet de la présente invention est donc de proposer une solution plus rapide et plus économique à la prédiction de l'évolution de l'état de dégradation d'une batterie électrique.

Les autres objets, caractéristiques et avantages de la présente invention apparaîtront à l'examen de la description suivante et des dessins d'accompagnement. Il est entendu que d'autres avantages peuvent être incorporés.

### RESUME

La présente invention concerne un procédé de prédiction de l'état de dégradation d'au moins une batterie électrique, de préférence pour véhicule électrique, ledit procédé étant configuré pour être exécuté par au moins un système électronique, de préférence ledit système électronique étant configuré pour communiquer avec au moins une base de données et/ou au moins un ensemble de capteurs, ledit procédé comprenant:
a. Une première étape de collecte, de préférence exécutée par au moins un premier module de collecte dudit système électronique, d'au moins une information relative à un protocole de cyclage initial, de préférence ledit protocole de cyclage initial correspondant au protocole de cyclage actuel de ladite batterie électrique, ledit protocole de cyclage initial étant pris parmi au moins la pluralité de protocoles de cyclages suivante :
   i. Un premier protocole de cyclage, ledit premier protocole de cyclage étant un protocole de cyclage à courant constant et à tension constante ;
   ii. Un deuxième protocole de cyclage, ledit deuxième protocole de cyclage étant un protocole de cyclage à courant pulsé ;
   iii. Un troisième protocole de cyclage, ledit troisième protocole de cyclage étant un protocole de cyclage de courant à plusieurs étages ;
b. Une étape de sélection, de préférence exécutée par au moins un module de sélection dudit système électronique, d'au moins deux protocoles de cyclage de prédiction pris parmi ladite pluralité de protocoles de cyclage y incluant le premier protocole et le deuxième protocole de cyclage ;
c. Une deuxième étape de collecte, de préférence exécutée par au moins un deuxième module de collecte dudit système électronique, d'au moins une donnée relative à au moins un ensemble de paramètres, ledit ensemble de paramètres comprenant au moins l'un des paramètres suivants :
   i. Un état de charge initial de la batterie électrique ;
   ii. Un état de charge final de la batterie électrique ;
   iii. Un nombre N de cycles de charges-décharges de ladite batterie ;
   iv. Une température T de la batterie électrique ;
   v. Un taux de charge C, c'est-à-dire une vitesse de charge, associé à au moins un protocole de cyclage pris parmi au moins ladite pluralité de protocoles de cyclage ;
d. Une étape de traitement, de préférence exécutée par au moins un module de calcul dudit système électronique, par apprentissage automatique à partir d'au moins un modèle mathématique pré-entrainé, de ladite au moins une information, de ladite au moins une donnée et de chaque protocole de cyclage de prédiction sélectionné, ladite étape de traitement comprenant au moins :
   i. Une étape de calcul d'au moins un descripteur par application dudit modèle mathématique pré-entrainé dans un espace de calcul multidimensionnel, ledit espace de calcul multidimensionnel étant configuré de sorte que chaque paramètre dudit ensemble de paramètres définisse une dimension dudit espace de calcul multidimensionnel ;
   ii. Une étape de classification de l'état de dégradation à partir dudit descripteur relativement à un ensemble de classes prédéterminées ;
   iii. Une étape de calcul de l'évolution temporelle dudit état de dégradation de ladite batterie électrique, par calcul d'une pluralité d'états de dégradation de ladite batterie électrique, en fonction d'au moins une variable, ladite variable étant prise parmi au moins :
      A) Un état de charge initial de la batterie électrique ;
      B) Un état de charge final de la batterie électrique ;
      C) Une pression appliquée à au moins une partie de la batterie électrique ;
      D) Un nombre N' de cycles de charges-décharges de ladite batterie électrique ;
      E) Une température T' de la batterie électrique ;
      F) Un premier taux de charge C1 relatif au premier protocole de cyclage ;
      G) Un deuxième taux de charge C2 relatif au deuxième protocole de cyclage ;
      H) Un troisième taux de charge C3 relatif au troisième protocole de cyclage ;
      I) Un premier taux de décharge D1 relatif au premier protocole de cyclage ;
      J) Un deuxième taux de décharge D2 relatif au deuxième protocole de cyclage ;
      K) Un troisième taux de décharge D3 relatif au troisième protocole de cyclage ;
      L) Une limite de charge ;
      M) Un temps de pause à courant nul ;
      N) Un autre protocole de cyclage ;
   iv. Une étape d'obtention d'un état calculé de la dégradation de ladite batterie électrique, ledit état calculé comprenant au moins un modèle mathématique prédictif, ledit modèle mathématique prédictif étant configuré pour représenter mathématiquement l'évolution de l'état de dégradation de ladite batterie électrique en fonction au moins de ladite variable,
      le procédé comprenant au moins une **étape de contrôle rétroactif,** par au moins un système de gestion (40) de la batterie électrique (10), d'au moins une variable en fonction dudit modèle mathématique prédictif et/ou d'au moins une consigne prédéterminée.

La présente invention utilise astucieusement un modèle mathématique pré-entrainé sur des données de diverses batteries électriques pour générer un modèle mathématique prédictif propre à une batterie électrique considérée. Cela permet un gain de temps et de ressource système considérable car il n'est alors pas nécessaire de reconstruire un modèle mathématique en partant de zéro.

La présente invention permet d'améliorer la qualité et la fiabilité des batteries électriques. Une des nombreuses applications de la présente invention consiste à aider les fabricants de batteries électriques à améliorer la qualité et la fiabilité de leurs batteries en réduisant le nombre de pannes prématurées.

La présente invention permet d'optimiser les paramètres de production d'une batterie électrique. En effet, le fabricant peut utiliser les résultats d'une prédiction pour ajuster les paramètres de production afin de ralentir la dégradation de la batterie et ainsi améliorer la qualité de la batterie sans compter sur des tests de cyclage, ce qui peut être à la fois long et coûteux. La présente invention est simple et facile à mettre en œuvre et permet de produire des résultats rapides, ce qui entraîne des économies de coûts et une meilleure efficacité de la production de batteries électriques.

La présente invention permet de réduire l'impact environnemental des batteries électriques. En effet, en prolongeant la durée de vie des batteries électriques, le nombre de batteries électriques nécessaires peut ainsi être réduit, réduisant ainsi l'impact environnemental de la production et de l'élimination des batteries électriques.

De plus, la présente invention permet une optimisation de la gestion d'une batterie électrique. En effet, en utilisant les résultats de la prédiction de l'évolution de l'état de dégradation d'une batterie électrique, un utilisateur peut alors optimiser la gestion de la batterie électrique en ajustant les conditions de cyclage et/ou de stockage, par exemple non limitatif, pour prolonger la durée de vie de la batterie électrique et éviter une dégradation prématurée.

De plus, la présente invention permet de planifier la maintenance et les réparations des batteries électriques. En effet, en anticipant la dégradation de la batterie électrique, un utilisateur peut planifier la maintenance et les réparations en conséquence, ce qui peut réduire les coûts et améliorer la disponibilité des batteries électriques.

Enfin, la présente invention permet d'améliorer l'efficacité énergétique de la filière des batteries électriques. En effet, en prolongeant la durée de vie d'une batterie électrique, un utilisateur peut ainsi réduire la fréquence de remplacement de la batterie électrique, ce qui peut réduire la consommation d'énergie et améliorer l'efficacité énergétique de la filière.

La présente invention concerne également un produit programme d'ordinateur, de préférence enregistré sur un support de mémoire non transitoire, comprenant des instructions, qui lorsqu'elles sont effectuées par au moins l'un parmi un processeur, un ordinateur, exécute le procédé selon la présente invention.

La présente invention concerne aussi un support de mémoire non transitoire comprenant un produit programme d'ordinateur selon la présente invention.

La présente invention concerne également un système électronique configuré pour exécuter un procédé selon la présente invention, ledit système électronique comprenant au moins :
a. Un module de communication configuré pour communiquer avec au moins une base de données et/ou au moins un ensemble de capteurs ;
b. Un premier module de collecte configuré pour collecter, de préférence via le module de communication, une information relative au protocole de cyclage initial de la batterie électrique ;
c. Un module de sélection configuré pour sélectionner au moins un protocole de cyclage de prédiction parmi une pluralité de protocoles de cyclage ;
d. Un deuxième module de collecte configuré pour collecter, de préférence via le module de communication, une donnée relative à un ensemble de paramètres ;
e. Un module de calcul configuré pour :
   i. Traiter par apprentissage automatique à partir d'au moins un modèle mathématique pré-entrainé, ladite au moins une information, ladite au moins une donnée et un protocole de cyclage de prédiction ;
   ii. Calculer au moins un descripteur par application dudit modèle mathématique pré-entrainé dans un espace de calcul multidimensionnel ;
   iii. Classifier l'état de dégradation de ladite batterie électrique à partir dudit descripteur relativement à un ensemble de classes prédéterminées ;
   iv. Calculer l'évolution temporelle dudit état de dégradation de ladite batterie électrique, par calcul d'une pluralité d'états de dégradation de ladite batterie électrique, en fonction d'au moins une variable, ladite variable étant prise parmi au moins :
      A) Un état de charge initial de la batterie électrique ;
      B) Un état de charge final de la batterie électrique ;
      C) Une pression appliquée à au moins une partie de la batterie électrique ;
      D) Un nombre N' de cycles de charges-décharges de ladite batterie électrique ;
      E) Une température T' de la batterie électrique ;
      F) Un premier taux de charge C1 relatif au premier protocole de cyclage ;
      G) Un deuxième taux de charge C2 relatif au deuxième protocole de cyclage ;
      H) Un troisième taux de charge C3 relatif au troisième protocole de cyclage ;
      I) Un premier taux de décharge D1 relatif au premier protocole de cyclage ;
      J) Un deuxième taux de décharge D2 relatif au deuxième protocole de cyclage ;
      K) Un troisième taux de décharge D3 relatif au troisième protocole de cyclage ;
      L) Une limite de charge ;
      M) Un temps de pause à courant nul ;
      N) Un autre protocole de cyclage ;
   v. Générer au moins un modèle mathématique prédictif, ledit modèle mathématique prédictif étant configuré pour représenter mathématiquement l'évolution de l'état de dégradation de ladite batterie électrique en fonction au moins de ladite variable.

En particulier, lors du développement de la présente invention un modèle mathématique d'apprentissage automatique capable de classer les conditions de vieillissement en fonction du taux de dégradation d'une LiB a été développé. Ce modèle a été conçu via l'utilisation d'un ensemble de données réelles issues d'un fabricant de batteries électriques pour véhicules électriques. Ce travail de développement a permis d'identifier les modèles et les relations entre le processus de vieillissement et différents facteurs dans un vaste espace multi-paramètre. Un modèle mathématique pré-entrainé a ainsi été conçu permettant de prédire le taux de dégradation des LiB dans différentes conditions de cycle. La présente invention a généré des résultats très intéressants permettant de surveiller et d'atténuer efficacement le vieillissement de la batterie dans les véhicules électriques.

On rappellera simplement ici que les méthodes d'apprentissage automatique permettent de tirer parti de grandes quantités de données pour identifier les modèles et les relations entre divers facteurs et par exemple le processus de vieillissement d'une batterie électrique. Ce type de modèle pré-entrainé permet ainsi, à partir de données propres à une batterie électrique donnée, de prédire l'évolution de son état de dégradation en fonction de diverses variables via la génération d'un nouveau modèle mathématique prédictif propre à ladite batterie électrique.

Ainsi, on connaît de l'art antérieur, notamment de l'article « Joint modeling for early predictions of Li-ion battery cycle life and degradation trajectory » (Energy, Volume 277, (2023), 127633, ISSN 0360-5442, by Zhang Chen, Liqun Chen, Zhengwei Ma, Kangkang Xu, Yu Zhou, Wenjing Shen), le principe général d'utiliser des méthodes d'apprentissage automatique pour faire des estimations et des prédictions en rapport avec le cycle de vie et l'évolution de la dégradation d'une batterie Li-ion. Mais les méthodes de l'art antérieur manquent encore de précision et de fiabilité.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
[Fig.1] La figure 1 représente une méthode de prédiction selon un mode de réalisation de la présente invention.
[Fig.2] La figure 2 représente un système électronique de prédiction selon un mode de réalisation de la présente invention.
[Fig.3] La figure 3 représente une boucle rétroactive de pilotage du système de gestion d'une batterie électrique selon un mode de réalisation de la présente invention.
[Fig.4] La figure 4 représente l'obtention d'un graphique d'aide à la décision dans le cadre d'un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les dimensions ne sont pas représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées en association ou alternativement :

Selon un exemple, la présente invention comprend au moins une étape d'affichage, par au moins un module d'affichage dudit système électronique, d'au moins une représentation graphique dudit modèle mathématique prédictif.

Selon un exemple, la présente invention comprend au moins une étape d'interaction par un utilisateur avec ledit modèle mathématique prédictif via une interface utilisateur dudit système électronique.

Selon un exemple, à l'étape de de contrôle rétroactif, le système de gestion de la batterie électrique ajuste des paramètres de charge et de décharge de la batterie. Ainsi le système de gestion de la batterie (calculateur BMS) peut, au regard des prédictions renvoyées par le modèle mathématique et au regard de l'évolution temporelle prévue, décider de limiter la vitesse de charge ou non, et/ou le cas échéant introduire un facteur de derating pour la décharge ou à l'inverse ne pas introduire de limites voire les repousser. Le calculateur BMS peut ainsi optimiser la durée de vie de la batterie électrique et réduire le risque de panne prématurée.

Selon un exemple, le système de gestion de la batterie électrique sélectionne opérationnellement un protocole de cyclage parmi la pluralité de protocoles de cyclages. Cette décision sur le protocole de cyclage peut être applicable pour le cycle de recharge en cours ou bien les prochains cycles de recharge ou bien la totalité des cycles de recharge à venir.

Par exemple, le calculateur BMS peut décider de basculer du premier protocole de cyclage (à courant constant et à tension constante 'CC-CV') vers le deuxième protocole de cyclage à courant pulsé. De manière alternative, le calculateur BMS peut décider le basculement inverse. De manière similaire, le calculateur BMS peut décider de basculer vers ou depuis le troisième protocole de cyclage.

Selon un exemple, le système de gestion 40 de la batterie électrique 10 planifie les calendriers de maintenance de la batterie électrique. Moyennant quoi, l'utilisateur du véhicule peut être informé d'un passage nécessaire au garage concernant la batterie de traction du véhicule. L'utilisateur peut aussi être informé possiblement d'une date future prévue de passage d'un seuil concernant la capacité restante intrinsèque de la batterie électrique (ex 90% ou 85%).

Selon un exemple, l'étape de pilotage ou contrôle rétroactif est réalisée en temps réel.

Selon un exemple, le modèle mathématique pré-entrainé a été entrainé sur des données de diverses batteries électriques en utilisant des données de batteries électriques issues de constructeurs, intégrateurs ou utilisateurs.

On remarque ici que le modèle mathématique pré-entraîné peut concerner plusieurs variantes de batteries s'agissant de cellules électrochimiques, tant sur le plan de leur électrochimie intrinsèque que sur le plan des facteurs de forme des cellules (cylindrique, prismatique, 'pouch', etc).

Le calculateur BMS pourra utiliser la branche du modèle mathématique pré-entraîné qui correspond le mieux au type de cellules électrochimiques contenues dans la batterie électrique du véhicule d'intérêt.

Selon un exemple, ledit ensemble de paramètres comprend au moins les paramètres suivants :
- un état de charge initial de la batterie électrique ;
- un nombre N de cycles de charges-décharges de ladite batterie ;
- une température T de la batterie électrique ;
- un taux de charge C, c'est-à-dire une vitesse de charge, associé à au moins un protocole de cyclage pris parmi au moins ladite pluralité de protocoles de cyclage. Ceci représente à minima un état courant de la batterie électrique.

Selon un exemple, l'étape de sélection (120) d'au moins deux protocoles de cyclage de prédiction pris parmi la pluralité de protocoles de cyclage comprend trois protocoles de cyclage à savoir le premier protocole, le deuxième protocole et le troisième protocole de cyclage. Le calculateur BMS a ainsi 3 protocoles de cyclage à sa disposition pour optimiser la durée de vie de la batterie électrique.

Il n'est non plus exclu d'utiliser un quatrième protocole de cyclage.

Selon un exemple, au moins l'une parmi respectivement la première étape de collecte et la deuxième étape de collecte comprend l'acquisition respectivement de ladite information et de ladite donnée à partir d'au moins une base de données et/ou d'au moins un ensemble de capteurs.

Selon un exemple, la présente invention concerne un système électronique qui comprend :
a. au moins un module d'affichage configuré pour afficher au moins une représentation graphique dudit modèle mathématique, et
b. au moins une interface utilisateur configurée pour permettre au moins une interaction par un utilisateur avec ledit modèle mathématique prédictif.

On remarque que le système de gestion de batterie autrement dit le calculateur BMS est embarqué et effectue des opérations en local, mais bénéficie par ailleurs d'un accès au modèle mathématique pré-entraîné qui forme une synthèse d'un ensemble très important de connaissances accumulées antérieurement au cours des profils de mission des batteries électriques sur un nombre important de véhicules.

On remarque qu'il est possible d'avoir au moins en partie le modèle mathématique pré-entraîné dans la mémoire du calculateur BMS. Dans un exemple de réalisation, toutefois, le modèle mathématique pré-entraîné est logé dans un serveur ou dans un 'cloud' et peut être mis à disposition du calculateur BMS via des moyens de communication à distance.

On remarque que le modèle mathématique pré-entraîné est constamment mis à jour par l'accumulation de nouvelles connaissances relative au profil de mission des batteries électriques sur des véhicules des flottes qui roulent. Ainsi, le modèle mathématique pré-entraîné et son ou ses descripteurs ne cessent d'être améliorés, ce qui augmente la pertinence des décisions que prend le calculateur BMS à partir de l'évolution prédite à partir du modèle.

De plus, la description ci-après énumérant les principes, les aspects et les mises en œuvre de la présente invention, ainsi que leurs exemples spécifiques, vise à englober à la fois leurs équivalents structurels et fonctionnels, qu'ils soient actuellement connus ou développés à l'avenir. Ainsi, par exemple, il sera apprécié par la personne de l'art que tous les schémas fonctionnels ici représentent des vues conceptuelles de circuits illustratifs incorporant les principes de la présente invention. De manière similaire, on comprendra que tous les organigrammes, et similaires, représentent divers processus qui peuvent être sensiblement représentés sur des supports lisibles par ordinateur et ainsi exécutés par un ordinateur ou un processeur, que cet ordinateur ou processeur soit explicitement représenté ou non.

Les fonctions des différents éléments représentés sur les figures, y compris tout bloc fonctionnel dénommé « processeur » ou « module », peuvent être assurés par l'utilisation d'un matériel dédié ainsi que d'un matériel capable d'exécuter un logiciel en association avec un programme informatique ou des instructions appropriés. Lorsqu'elles sont fournies par un processeur, les instructions peuvent être fournies par un seul processeur dédié, par un seul processeur partagé, ou par une pluralité de processeurs individuels, dont certains peuvent être partagés. Dans certains modes de réalisation de la présente invention, le processeur peut être un processeur à usage général, tel qu'une unité centrale de traitement (CPU), par exemple. De plus, l'utilisation explicite du terme "processeur" ne doit pas être interprétée comme se référant exclusivement à du matériel capable d'exécuter des logiciels et peut implicitement inclure, sans s'y limiter, un circuit intégré spécifique à une application (ASIC), un réseau de portes programmables sur le terrain (FPGA), une mémoire morte (ROM) pour stocker des logiciels, une mémoire vive (RAM) et un stockage non volatile. D'autres matériels, conventionnels et/ou personnalisés, peuvent également être inclus.

Les modules logiciels, ou simplement les modules qui sont supposés être des logiciels, peuvent être représentés ici comme n'importe quelle combinaison d'éléments d'organigramme ou d'autres éléments indiquant l'exécution d'étapes de processus et/ou une description textuelle. De tels modules peuvent être exécutés par un matériel qui est expressément ou implicitement représenté. De plus, il doit être compris que le module peut inclure par exemple, mais sans s'y limiter, une logique de programme informatique, des instructions de programme informatique, un logiciel, un micrologiciel, des circuits matériels ou une combinaison de ceux-ci qui fournit les capacités requises.

La présente invention propose d'utiliser un modèle d'apprentissage automatique pour classer les conditions de cyclage de vieillissement en fonction du taux de dégradation de batteries électriques et en particulier de batteries Li-ion (LiB), et pour générer un modèle mathématique prédictif configuré pour prédire l'évolution dans le temps de l'état de santé d'une batterie électrique donnée en fonction de diverses variables et/ou paramètres. On notera que dans la suite de la description les termes « batterie électrique », « batterie Li-ion » ou encore « LiB » s'interprète de manière identique.

De manière astucieuse, la présente invention utilise un ensemble de données provenant de conditions réelles d'utilisation de batteries électriques fonctionnant dans diverses conditions pour identifier les relations entre le processus de vieillissement et différents facteurs dans un vaste espace multiparamétrique. En particulier, la présente invention peut s'appliquer au domaine automobile de manière non limitative.

Tel que présenté par la suite, la présente invention permet de prédire le taux de dégradation d'une batterie électrique, de préférence de type Li-ion, dans différentes conditions de cycle/stockage.

De manière inattendue, la présente invention permet d'identifier les différents facteurs qui influencent le processus de vieillissement d'une batterie électrique. Les corrélations significatives observées lors du développement de la présente invention permettent de déterminer quelles variables ont l'impact le plus significatif sur le taux de dégradation d'une batterie électrique.

Ces variables peuvent correspondre à des mécanismes de vieillissement spécifiques, et les résultats sont essentiels pour optimiser les conceptions de systèmes de gestion de batterie capables de surveiller et de limiter efficacement le vieillissement d'une batterie électrique dans les véhicules électriques, par exemple non limitatif. La présente invention permet une amélioration des performances, une plus grande fiabilité et la résolution des problèmes de durabilité de la batterie électrique d'un véhicule, par exemple non limitatif.

La présente invention fournit un outil précieux pour prédire, par au moins un modèle mathématique prédictif, les performances et la durée de vie des batteries électrique, de préférence Li-ion, avantageusement dans les véhicules électriques, dans différentes conditions de cycle et de stockage. La capacité d'identifier les facteurs qui influencent le vieillissement de la batterie et de prévoir ses effets peut conduire à des améliorations significatives dans la conception et l'utilisation de la batterie, contribuant finalement au développement de véhicules électriques plus efficaces et durables.

De plus, la présente invention trouve pour application très astucieuse le pilotage, sous forme d'une boucle rétroactive par exemple, du système de gestion de la batterie dit BMS, de l'acronyme anglais « Battery Management System ».

En effet, par exemple, en fournissant des prédictions de l'état de dégradation de la batterie électrique en temps réel, la présente invention permet un pilotage intelligent du BMS.

En effet, par exemple, en surveillant, régulièrement et/ou en permanence, les conditions de cyclage de la batterie et en saisissant les données dans la présente invention, i.e. dans un modèle mathématique étant configuré pour représenter mathématiquement l'évolution de l'état de dégradation de ladite batterie, le système de gestion de la batterie BMS peut utiliser le modèle mathématique généré pour prédire l'état de dégradation de la batterie électrique en fonction de divers paramètres et ainsi peut ajuster certains au moins de ces paramètres, comme par exemple les paramètres de charge et de décharge de la batterie électrique. Cela peut aider à optimiser la durée de vie de la batterie électrique et à réduire le risque de panne prématurée.

En outre, la présente invention peut également aider le BMS à planifier les calendriers de maintenance et de réparation en fonction du taux de dégradation calculé et donc prévu. En planifiant la maintenance et les réparations à l'avance, le BMS peut réduire le risque de pannes inattendues et minimiser les temps d'arrêt.

Ainsi, selon un mode de réalisation préféré, la présente invention concerne un procédé de prédiction de l'état de dégradation d'au moins une batterie électrique. Ladite batterie électrique étant par exemple configurée pour coopérer avec un véhicule électrique.

Le procédé selon la présente invention est avantageusement configuré pour être exécuté par au moins un système électronique. Ce système électronique, dit de prédiction, est de préférence configuré pour communiquer avec au moins une base de données et/ou au moins un premier ensemble de capteurs tel que décrit par la suite.

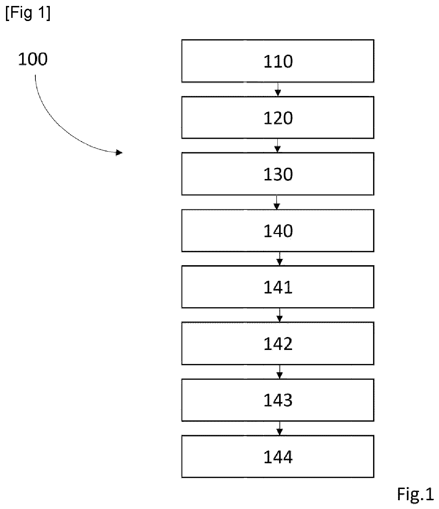

Selon un mode de réalisation, et tel qu'illustré par la figure 1, le procédé de prédiction 100 de l'état de dégradation d'une batterie électrique 10 comprend au moins :
a. Une première étape de collecte 110, exécutée par au moins un premier module de collecte 210 dudit système électronique 200, d'au moins une information relative à un protocole de cyclage initial, également appelé protocole de charge/décharge initial. De préférence, ledit protocole de cyclage initial correspond au protocole de cyclage actuel de ladite batterie électrique 10. Comme discuté ci-après, le premier protocole de cyclage initial est pris parmi au moins la pluralité de protocoles de cyclages suivante :
   i. Un premier protocole de cyclage, ledit premier protocole de cyclage étant un protocole de cyclage à courant constant et à tension constante ;
   ii. Un deuxième protocole de cyclage, ledit deuxième protocole de cyclage étant un protocole de cyclage à courant pulsé ;
   iii. Un troisième protocole de cyclage, ledit troisième protocole de cyclage étant un protocole de cyclage de courant à plusieurs étages ;
b. Une étape de sélection 120, exécutée par au moins un module de sélection 220 dudit système électronique 200, d'au moins un protocole de cyclage de prédiction parmi ladite pluralité de protocoles de cyclage ; De manière avantageuse, deux protocoles de cyclage de prédiction peuvent être sélectionnés ;
c. Une deuxième étape de collecte 130, exécutée par au moins un deuxième module de collecte 230 dudit système électronique 200, d'au moins une donnée relative à au moins un ensemble de paramètres, ledit ensemble de paramètres comprenant au moins l'un des paramètres suivants :
   i. Un état de charge initial de la batterie électrique 10 ;
   ii. Un état de charge final de la batterie électrique 10 ;
   iii. Un nombre N de cycles de charges-décharges de ladite batterie 10 ;
   iv. Une température T de la batterie électrique 10 ;
   v. Un taux de charge C, c'est-à-dire une vitesse de charge, associé à au moins un protocole de cyclage pris parmi au moins ladite pluralité de protocoles de cyclage ;
d. Une étape de traitement 140, exécutée par au moins un module de calcul 240 dudit système électronique 200, par apprentissage automatique à partir d'au moins un modèle mathématique pré-entrainé, de ladite au moins une information, de ladite au moins une donnée et dudit protocole de cyclage de prédiction. Avantageusement, ladite étape de traitement 140 comprend au moins :
   i. Une étape de calcul 141 d'au moins un descripteur par application dudit modèle mathématique pré-entrainé dans un espace de calcul multidimensionnel, ledit espace de calcul multidimensionnel étant configuré de sorte que chaque paramètre dudit ensemble de paramètres définissent une dimension dudit espace de calcul multidimensionnel ;
   ii. Une étape de classification 142 de l'état de dégradation à partir dudit descripteur relativement à un ensemble de classes prédéterminées ;
   iii. Une étape de calcul 143 de l'évolution temporelle dudit état de dégradation de ladite batterie électrique (10), par calcul d'une pluralité d'états de dégradation de ladite batterie électrique, en fonction d'au moins une variable, ladite variable étant prise parmi au moins :
      A) Un état de charge initial de la batterie électrique 10 ;
      B) Un état de charge final de la batterie électrique 10 ;
      C) Une pression appliquée à au moins une partie de la batterie électrique 10, ladite pression étant de préférence prédéterminée et avantageusement fixe ;
      D) Un nombre N' de cycles de charges-décharges de ladite batterie électrique 10 ;
      E) Une température T' de la batterie électrique 10 ;
      F) Un premier taux de charge C1 relatif au premier protocole de cyclage ;
      G) Un deuxième taux de charge C2 relatif au deuxième protocole de cyclage ;
      H) Un troisième taux de charge C3 relatif au troisième protocole de cyclage ;
      I) Un premier taux de décharge D1 relatif au premier protocole de cyclage ;
      J) Un deuxième taux de décharge D2 relatif au deuxième protocole de cyclage ;
      K) Un troisième taux de décharge D3 relatif au troisième protocole de cyclage ;
      L) Une limite de de charge ;
      M) Un temps de pause à courant nul ;
      N) Un autre protocole de cyclage ;
   iv. Une étape de d'obtention 144 d'un état calculé de la dégradation de ladite batterie électrique 10, ledit état calculé comprenant au moins un modèle mathématique prédictif, ledit modèle mathématique prédictif étant configuré pour représenter mathématiquement l'évolution de l'état de dégradation de ladite batterie électrique 10 en fonction au moins de ladite variable, de préférence par variation d'au moins ladite variable.

Cela permet ainsi de prédire l'état de dégradation de la batterie électrique 10 en fonction des diverses variables.

Ainsi, la présente invention permet, à partir de certaines données de la batterie électrique, de générer un modèle mathématique prédictif de l'état de dégradation de la batterie électrique 10. Ce modèle mathématique prédictif permet alors de prédire, par la génération d'au moins un modèle mathématique prédictif, ledit état de dégradation en fonction de diverses variables, cela permettant de prédire l'état de dégradation de la batterie électrique en fonction de ces diverses variables.

Avantageusement, le modèle mathématique prédictif est une combinaison linéaire et/ou non-linéaire des paramètres, pondérés ou non, permettant une représentation mathématique dans un espace multidimensionnels de l'état de dégradation de la batterie électrique 10.

Selon un mode de réalisation, la première étape de collecte 110 est configurée pour déterminer le protocole de cyclage initial de la batterie électrique 10, c'est-à-dire son protocole actuel, c'est-à-dire celui qui lui est appliqué actuellement ou qui lui a été appliqué en dernier. On entend par « protocole de cyclage » le processus utilisé pour charger et décharger une batterie électrique 10, il peut également s'agir du processus utilisé pour tester et évaluer la performance, la durée de vie et la sécurité d'une batterie électrique 10. De préférence, un protocole de cyclage implique une série de charges et de décharges répétées.

Selon un mode de réalisation, nous allons considérer trois protocoles de charges distincts, toutefois on notera que la présente invention peut parfaitement être implémentée pour d'autres types de protocoles de charge existant à ce jour ou non.

Ainsi, selon un mode de réalisation non limitatif, la première étape de collecte 110 permet de recueillir au moins une donnée relative à la nature du protocole de cyclage initial d'une batterie électrique 10 considérée. Avantageusement, ce protocole de cyclage initial correspond à au moins un des trois protocoles suivants :
i. Un premier protocole de cyclage, également appelé protocole de cyclage à courant constant et à tension constante (CC-CV). Ledit premier protocole de cyclage est un protocole largement utilisé qui consiste à charger initialement la batterie électrique avec un courant constant prédéterminé jusqu'à ce qu'elle atteigne une tension prédéterminée, puis passer à une tension constante prédéterminé pour terminer le processus de charge. Ce premier protocole de cyclage vise à équilibrer la vitesse de charge et le contrôle de la tension pour éviter toute surcharge. Ce premier protocole de cyclage est couramment utilisé dans diverses applications et permet de fournir une charge efficace et contrôlée.
ii. Un deuxième protocole de cyclage, également appelé protocole de cyclage à courant pulsé. Ce deuxième protocole de cyclage consiste à appliquer de courtes rafales de courant élevé à la batterie électrique avec des périodes de repos intermédiaires, c'est-à-dire des temps de pause (voir par exemple l'article suivant : « Lv, H., Huang, X. & Liu, Y. Analysis on pulse charging-discharging strategies for improving capacity retention rates of lithium-ion batteries. Ionics 26, 1749-1770 (2020). »). Il est estimé par la personne du métier que cette technique de charge améliore la capacité de la batterie électrique, ses performances et réduit également son taux de dégradation.
iii. Un troisième protocole de cyclage également appelé protocole de cyclage de courant à plusieurs étages. Ce troisième protocole de cyclage est un protocole plus complexe que les deux précédents et qui implique plusieurs étapes de chargement avec différents niveaux de courant (voir par exemple l'article suivant : « Romain Mathieu, Olivier Briat, Philippe Gyan, Jean-Michel Vinassa. Fast charging for electric vehicles applications: Numerical optimization of a multi-stage charging protocol for lithium-ion battery and impact on cycle life. Journal of Energy Storage, 2021, 40, pp.102756.(10.1016/j.est.2021.102756). (hal-04087488) »).

On notera que les protocoles de cyclages précédemment décrits ont un impact différent sur l'état de dégradation, et donc de santé, d'une batterie électrique 10 et en particulier d'une LiB. La présente invention, lors de son développement, a montré que cet état de dégradation est fortement corrélé avec les conditions de fonctionnement de ladite batterie électrique 10.

De manière astucieuse, chaque protocole peut être caractérisé par plusieurs paramètres spécifiques. Ainsi, la dégradation des batteries électriques 10 et en particulier des LiB dépend, de préférence, d'un large ensemble de paramètres de cycle, i.e. de cycle de charge-décharge.

Ensuite, l'étape de sélection 120 permet de sélectionner un protocole de cyclage de prédiction, c'est-à-dire un protocole de cyclage pouvant être différent du protocole de cyclage initial et qui va servir de paramètre à la future prédiction. Ainsi, l'utilisateur peut décider de prédire l'état de dégradation d'une batterie électrique 10 si celle-ci est soumise à un protocole de cyclage particulier, i.e. sélectionné.

De manière avantageuse, la deuxième étape de collecte 130 permet de collecter au moins une donnée, et de préférence une pluralité de données, relatives à au moins un paramètre, de préférence à divers paramètres. Cette étape permet de collecter des informations, des données, sur l'état initial de batterie électrique 10, sur son état actuel. Ces données servent alors à définir l'état de la batterie électrique 10.

Nous allons à présent décrire un exemple de paramètres considérés par la présente invention, et en particulier lors de la deuxième étape de collecte 130. Ces divers paramètres ont été astucieusement sélectionnés car ils représentent les paramètres d'une batterie électrique 10 pouvant avoir l'impact le plus important sur le taux de dégradation de celle-ci :
a. L'état de charge initial de la batterie électrique 10 : L'état de charge initial de la batterie électrique 10 correspond à la quantité de charge électrique qu'elle détient par rapport à sa capacité maximale avant d'effectuer un cycle de charge-décharge, c'est-à-dire un cyclage ;
b. L'état de charge final de la batterie électrique 10 : L'état de charge final de la batterie électrique 10 correspond à la quantité de charge électrique qu'elle détient par rapport à sa capacité maximale après avoir effectué un cycle de charge-décharge, c'est-à-dire un cyclage ;
c. Le nombre N de cycles de charges-décharges de ladite batterie électrique 10 : Le nombre N de cycles de charge/décharge, c'est-à-dire de cyclage, est un paramètre qui peut fortement impacter la dégradation d'une LiB. En effet, plus ce nombre est élevé et plus le taux de dégradation de la batterie est élevé. En effet, le nombre de cycles répétés d'une batterie peut conduire à plusieurs mécanismes de dégradation réduisant la capacité de la batterie électrique 10 et ses performances dans le temps ;
d. La température T de la batterie électrique 10 : Durant l'élaboration de la présente invention, il a été observé que la température de fonctionnement de la batterie électrique 10 peut jouer un rôle important dans la compréhension de son taux de dégradation. Par exemple, en faisant varier la température dans une plage spécifique, il est possible d'évaluer les performances et le comportement de la batterie électrique 10 dans différentes conditions thermiques.
e. Le taux de charge C : Le taux de charge C correspond à la vitesse de charge, c'est-à-dire à la vitesse à laquelle la batterie électrique 10 est chargée. De préférence ce taux de charge est fonction du protocole de cyclage considéré. Lors du développement de la présente invention, il a été observé que le taux de charge peut avoir un impact significatif sur le comportement et les schémas de dégradation d'une LiB. Ainsi, on observe que des taux de charge plus élevés peuvent accélérer le processus de vieillissement et réduire la durée de vie globale de la batterie électrique 10. Le travail de développement de la présente invention a permis d'obtenir des informations précieuses sur les performances de la batterie électrique 10 dans différentes conditions de charge et de développer ainsi des stratégies d'optimisation.

Ces cinq paramètres ont été identifiés comme ceux présentant un effet important sur l'état de dégradation d'une batterie électrique 10.

Ensuite, vient l'étape de traitement 140. Cette étape de traitement utilise l'information relative au protocole de cyclage initial, la ou les données collectées relativement aux paramètres de fonctionnement de la batterie électrique 10 et le choix du protocole de cyclage de prédiction. Avec ces éléments et un modèle mathématique pré-entrainé, la présente invention permet générer au moins un descripteur. Ce descripteur est alors capable de classifier différent état de dégradation de la batterie électrique 10 en fonction de divers variables et paramètres. Avantageusement, le descripteur classe l'état de dégradation de la batterie 10 en fonction d'un ensemble de classes prédéterminées, comme par exemple : une première classe dite « high loss », une deuxième classe dite « very high loss », une troisième classe dite « low loss » et une quatrième classe dite « moderate loss ». La première classe peut ainsi correspondre à un taux de dégradation élevé. La deuxième classe peut correspondre à un taux de dégradation très élevé. La troisième classe peut correspondre à un taux de dégradation faible. La quatrième classe peut correspondre à un taux de dégradation modéré.

De manière avantageuse, la présente invention, en exploitant au moins une partie de ces paramètres et de préférence d'autres paramètres dits secondaires, permet de générer un modèle mathématique dit pré-entrainé. En effet, en utilisant des données issues de constructeurs, intégrateurs ou encore utilisateurs, le développement de la présente invention a permis de concevoir ce que l'on appelle une intelligence artificielle, c'est-à-dire un modèle mathématique pré-entrainé, permettant de traiter des données issues de paramètres relatifs à une batterie électrique 10 pour ensuite concevoir un modèle mathématique prédictif de l'état de dégradation de ladite batterie électrique 10, de préférence via une prédiction dudit état de dégradation en fonction de diverses variables.

On notera qu'une variable et un paramètre peuvent se référer à une même donnée ou grandeur physique. Toutefois, on parlera de paramètre lorsqu'il s'agit d'une donnée collectée et de variable lorsqu'il s'agit d'une donnée destinée à varier pour le calcul d'une prédiction, par exemple.

De préférence, la collecte de données a été une étape importante dans la construction d'un modèle mathématique prédictif basé sur l'apprentissage automatique lors du développement de la présente invention. Dans ce type de démarche, la qualité et la quantité des données collectées ont un impact direct sur l'exactitude et l'efficacité du modèle mathématique prédictif ainsi généré. De préférence, les données collectées incluent une large gamme de paramètres pour fournir une vue complète des performances de la batterie électrique 10 dans différentes conditions, permettant au modèle d'apprentissage automatique de faire des prédictions précises, c'est-à-dire de générer un modèle mathématique prédictif.

Les paramètres pris en considération pour la conception du modèle mathématique pré-entrainé comprennent les paramètres précédemment décrits et également des paramètres additionnels ou secondaires. Ces paramètres additionnels sont avantageusement les suivants :
a. Une pression P appliquée à au moins une partie de la batterie électrique 10, ladite pression étant de préférence prédéterminée et avantageusement fixe. Ce paramètre concerne l'application d'une pression P sur la batterie électrique 10 pendant un cyclage. Ce paramètre apporte une dimension de contraintes mécaniques, au modèle mathématique lors de sa conception, relativement aux performances de la batterie électrique 10 et à sa dégradation dans des conditions de contraintes mécaniques ;
b. Un taux de décharge D relatif au protocole de cyclage de la batterie électrique 10 : Lors du développement de la présente invention, différents taux de décharge ont été appliqués pour évaluer leur impact sur le processus de vieillissement de la batterie électrique 10 et ses performances globales. Il apparait que le taux de décharge D a un impact important sur la dégradation des performances d'une batterie électrique.
c. Une limite de charge L : Il s'agit d'imposer une limite à la charge d'une batterie électrique, comme par exemple 80% de sa capacité de charge totale. Il apparait que l'utilisation d'une limite de charge L a un impact important sur la dégradation des performances d'une batterie électrique.
d. Un temps de pause Tp à courant nul : Il s'agit d'imposer un temps d'arrêt lors de la charge et/ou de la décharge d'une batterie électrique 10. Pendant ce temps de repos, la batterie électrique 10 a la possibilité de se stabiliser et de récupérer de la contrainte imposée lors du cycle de charge ou de décharge précédent. La durée de la période de repos, i.e. temps de pause, peut influencer les performances de la batterie électrique 10. Il est à noter que des temps de repos trop courts peuvent entraîner une augmentation du stress sur la batterie électrique 10, accélérant potentiellement les mécanismes de dégradation. A l'inverse, de longs temps de repos peuvent permettre une meilleure relaxation des contraintes chimiques, et ainsi améliorer les performances et la longévité de la batterie électrique 10.

Nous allons présenter maintenant les variables pouvant être utilisées pour la prédiction de l'état de dégradation d'une batterie électrique 10 par la présente invention. Ces variables comprennent des paramètres qui ont été en partie du moins utilisés dans la conception du modèle mathématique pré-entrainé. Ces paramètres dits d'entrainement comprennent aussi les paramètres précédemment discutés. Ces paramètres d'entrainement deviennent des variables de prédiction lors de la prédiction de l'état de dégradation de la batterie électrique 10. Ces variables de prédiction ont pour fonction d'être utilisées comme variables ajustables, de préférence par un utilisateur, lors de la prédiction de l'état de dégradation de la batterie électrique 10. Ces variables sont de préférence les suivantes :
a. Un état de charge initial de la batterie électrique 10 ;
b. Un état de charge final de la batterie électrique 10 ;
c. Une pression P' appliquée à au moins une partie de la batterie électrique 10, ladite pression étant de préférence prédéterminée et avantageusement fixe ;
d. Un nombre N' de cycles de charges-décharges de ladite batterie électrique 10 ;
e. Une température T' de la batterie électrique 10 ;
f. Un premier taux de charge C1 relatif au premier protocole de cyclage ;
g. Un deuxième taux de charge C2 relatif au deuxième protocole de cyclage ;
h. Un troisième taux de charge C3 relatif au troisième protocole de cyclage ;
i. Un premier taux de décharge D1 relatif au premier protocole de cyclage ;
j. Un deuxième taux de décharge D2 relatif au deuxième protocole de cyclage ;
k. Un troisième taux de décharge D3 relatif au troisième protocole de cyclage ;
l. Une limite de de charge L' ;
m. Un temps de pause Tp' à courant nul ;
n. Un autre protocole de cyclage ;

On notera que pour la conception du modèle mathématique pré-entrainé, les variables/paramètres considérés ont soigneusement été contrôlés et ont varié dans une plage prédéterminée pour s'assurer que les données étaient représentatives des conditions réelles. Ce processus de collecte de données impliquait l'exécution de chaque protocole plusieurs fois et la collecte de données à intervalles de temps réguliers. Ces données ont ensuite été stockées dans une base de données pour le traitement et l'entraînement d'au moins un modèle d'apprentissage automatique. Pour cela des techniques bien connues par la personne du métier (voir par exemple le livre : « An Introduction to Statistical Learning, Gareth James, Daniela Witten, Trevor Hastie, Robert Tibshirani, Springer New York, NY, 2013, 978-1-4614-7138-7 »), comme les k-moyennes, appelées « K-means » en anglais, ou encore les machines à vecteur de support, appelées « SVM », ont été utilisées afin de prédire le taux de dégradation de la batterie électrique 10 en fonction des paramètres donnés. Ainsi, cela a permis de concevoir un modèle mathématique pré-entrainé servant de base à la création du modèle mathématique prédictif selon la présente invention. Ce modèle mathématique prédictif est lui conçu spécifiquement pour une batterie électrique 10 considérée et non pas pour une batterie électrique dite « générique » comme dans le cas du modèle mathématique pré-entrainé.

La création d'un modèle mathématique prédictif peut être long et complexe, c'est pourquoi la présente invention utilise un modèle mathématique pré-entrainé comme base de départ pour l'élaboration d'un modèle mathématique prédictif propre à une batterie électrique 10, cette approche permet un gain considérable de temps et de ressources système.

Lors du développement de la présente invention, une étape de prétraitement des données a été fort utile. En effet, une fois les données collectées, elles ont été prétraitées pour les adapter aux algorithmes d'apprentissage automatique. Cela inclut le nettoyage des données, la suppression de toutes les fonctionnalités non pertinentes ou redondantes et la transformation des données en un format numérique pouvant être introduit dans les modèles d'apprentissage automatique.

Ensuite, les données prétraitées ont été divisées en ensembles d'apprentissage et de test. La technique des k-moyennes a été utilisée pour regrouper des points de données similaires, puis des machines à vecteurs de support SVM sont formées sur chaque groupe ou cluster pour prédire le taux de dégradation des batteries électriques 10 pour un groupe particulier de données.

Pour rappel, l'analyse non supervisée des k-moyennes vise à identifier k groupes dans l'ensemble de données en optimisant les distances entre chaque point et les données présentant des similitudes et en maximisant les séparations de clusters à l'aide des métriques prédéfinies et connues de la personne du métier.

L'avantage d'utiliser une classification multi-paramètres est qu'elle peut gérer des données et capturer les relations non linéaires entre les paramètres d'entrée et l'état de dégradation de la batterie électrique 10. Elle fournit un cadre flexible et adaptable pour intégrer différentes fonctionnalités et optimiser les limites de décision pour classer avec précision la dégradation de la batterie électrique 10.

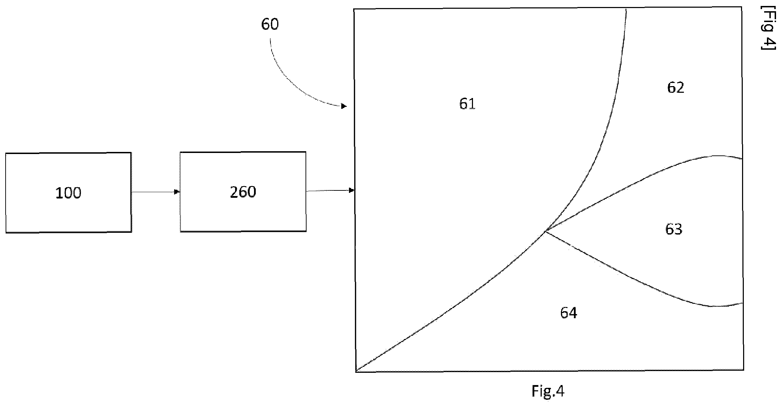

Une fois la machine à vecteurs de support SVM créée, elle peut être utilisée pour prédire le classement de nouveaux points de données. Afin de faciliter la compréhension et la prise de décision pour un utilisateur, un diagramme de décision 60 tel qu'illustré en figure 4 peut être créé et permet d'illustrer les limites entre les différentes classes dans un jeu de données du modèle SVM. Le diagramme de décision 60 est une représentation visuelle des limites de décision produites par le classificateur SVM. Selon un mode de réalisation, le diagramme de décision 60 peut être généré par le modèle mathématique prédictif.

Un graphique de décision peut montrer les limites de décision que la SVM a apprises à partir des données d'apprentissage. Les points d'un côté de la frontière sont classés comme appartenant à une classe, tandis que les points de l'autre côté sont classés comme appartenant à une classe différente. De manière avantageuse et tel que décrit par la suite, la visualisation de ces données peut être faite sur différents couples de paramètres d'entrée, c'est-à-dire en fonction de divers paramètres tels que ceux décrits précédemment. Par conséquent, l'utilisateur peut contrôler l'axe des tracés, c'est-à-dire choisir les variables d'entrée qu'il souhaite visualiser.

Ainsi, de manière avantageuse, le procédé selon la présente invention peut également comprendre au moins une étape d'affichage, par au moins un module d'affichage 260 dudit système électronique 200, d'au moins une représentation graphique 60 dudit deuxième modèle mathématique. Cette étape d'affichage est par exemple fort utile pour représenter l'état de dégradation calculé à un utilisateur via un écran, par exemple. On peut aisément imaginer que la présente invention équipe un véhicule électrique et que le conducteur puisse via son tableau de bord savoir quand sa batterie 10 risque de tomber en panne et donc savoir quand l'entretien de la batterie 10 devrait être planifié.

De préférence, le procédé selon la présente invention peut également comprendre une étape d'interaction par un utilisateur avec ledit modèle mathématique prédictif via une interface utilisateur 260 dudit système électronique 200. Dans cette situation, l'utilisateur pourrait par exemple faire varier une variable de la prédiction et ainsi voir en temps réel l'évolution de l'état de dégradation de la batterie électrique 10 dans le temps. Par exemple, l'utilisateur pourrait charger sa batterie 10 selon le premier protocole de cyclage, mais lorsqu'il réalise cette prédiction, et qu'il change pour le second protocole de cyclage, il pourrait se rendre alors compte que le second protocole de cyclage pourrait être plus avantageux pour sa batterie 10 compte tenu de celle-ci et de ses paramètres propres.

Ainsi, par exemple, le développement d'une interface utilisateur graphique (GUI) 260 est une étape du développement de la présente invention qui a permis de rendre le second modèle mathématique prédictif plus accessible à un public plus large, y compris les chercheurs, les ingénieurs et les concepteurs travaillant sur les systèmes de batterie, et surtout à l'utilisateur final, par exemple le conducteur d'un véhicule électrique 10. L'interface graphique 260 fournit de préférence une interface intuitive et conviviale qui permet à l'utilisateur de contrôler facilement les différents paramètres d'entrée qui affectent le processus de vieillissement des batteries 10 lithium-ion, i.e. qui affectent la prédiction.

Cet outil permet à l'utilisateur de saisir ses propres données de cyclage et d'obtenir une prédiction du taux de dégradation de sa batterie électrique 10. L'utilisateur peut également visualiser les résultats prévus sous la forme de graphiques de décision 60. Ce type de graphique peut comprendre diverses zones 61, 62, 63 et 64 indiquant différents scénarii en fonction de paramètres d'entrée. Ainsi la présente invention permet également une meilleure prise de décision. La figure 4 montre un exemple d'implémentation d'une telle interface graphique 260. Sur cette figure la première classe 61 est illustrée, ainsi que la deuxième classe 62, la troisième classe 63 et la quatrième classe 64, tel que précédemment décrite.

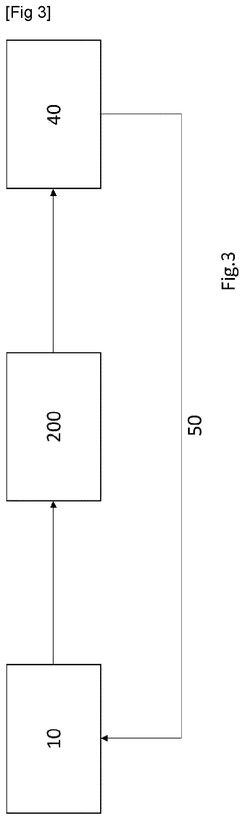

Selon un mode de réalisation avantageux, le procédé peut également comprendre au moins une étape de contrôle rétroactif, via le BMS 40 par exemple, d'au moins un paramètre de la batterie 10. Ce mode de réalisation est illustré en figure 3. Sur cette figure, une boucle rétroactive de pilotage 50 est illustrée. En effet, le système électronique 200 ayant généré le modèle mathématique prédictif via le procédé 100, il est alors possible au BMS 40 d'exploiter ce modèle mathématique prédictif pour ajuster un ou plusieurs paramètres de la batterie électrique 10, de préférence en temps réel, de sorte à opérer une optimisation de ses performances.

Il est à noter que selon un mode de réalisation, la première étape de collecte 110 de ladite moins une information relative à un protocole de cyclage initial peut comprendre une étape d'acquisition de ladite information d'au moins une base de données 20 et/ou d'au moins un ensemble de capteurs 30.

Selon un mode de réalisation, le système électronique est en communication, via un module de communication 260, avec une base de données 20 et/ou un ensemble de capteurs 30. Cet ensemble de capteurs 30 est configuré pour permettre la mesure, de préférence en temps réel, de divers paramètres d'une batterie électrique 10.

La présente invention concerne également un produit programme d'ordinateur comprenant une pluralité d'instructions qui lorsqu'elles sont exécutées par au moins un processeur exécutent la méthode 100 selon la présente invention.

La présente invention concerne également un support de mémoire non transitoire comprenant un produit programme d'ordinateur selon la présente invention.

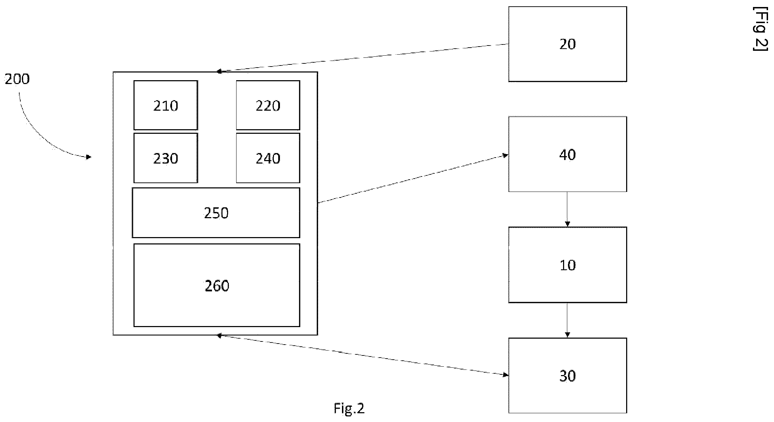

Nous allons à présent décrire, au travers de la figure 2, un système électronique 200 selon un mode de réalisation de la présente invention. De préférence, ce système électronique 200 comprend au moins un processeur et avantageusement au moins une mémoire non transitoire.

Ce système électronique 200 est de préférence configuré pour exécuter le procédé 100. Ce système électronique 200 comprend avantageusement au moins :
a. Un module de communication 260. Ce module de communication 260 est de préférence configuré pour communiquer avec au moins une base de données 20 et/ou au moins un ensemble de capteurs 30 ;
b. Un premier module de collecte 210. Ce premier module de collecte 210 est avantageusement configuré pour collecter, de préférence via le module de communication 260, au moins une information relative à au protocole de cyclage initial d'une batterie électrique 10 considérée ;
c. Un module de sélection 220. Ce module de sélection 220 est de préférence configuré pour sélectionner au moins un protocole de cyclage de prédiction parmi une pluralité de protocoles de cyclage ;
d. Un deuxième module de collecte 230. Ce deuxième module de collecte 230 peut être identique au premier module de collecte 210 selon un mode de réalisation. Ce deuxième module de collecte 230 est avantageusement configuré pour collecter, de préférence via le module de communication 260, au moins une donnée relative à un ensemble de paramètres ;
e. Un module de calcul 240. Ce module de calcul 240 comprend avantageusement au moins un modèle mathématique pré-entrainé. Ce module de calcul 240 est avantageusement configuré pour traiter par apprentissage automatique ladite information, ladite donnée et ledit protocole de cyclage de prédiction. Ce module de calcul 240 est de préférence configuré pour prédire un état de dégradation de ladite batterie électrique 10 en générant au moins un modèle mathématique prédictif configuré pour représenter mathématiquement au moins une évolution de l'état de dégradation de ladite batterie électrique 10.

On notera qu'un module peut comprendre un ou plusieurs autres modules.

Selon un mode de réalisation, le système électronique 200 peut comprendre un module d'affichage. Ce module d'affichage, comme indiqué précédemment, peut être configuré pour afficher au moins une représentation graphique dudit modèle mathématique prédictif. Cette représentation graphique peut être une aide à la prise de décision.

De préférence, le système électronique 200 peut comprendre une interface utilisateur 260. Cette interface utilisateur 260 peut être configurée pour permettre au moins une interaction par un utilisateur avec ledit modèle mathématique prédictif. Cela lui permet de sélectionner par exemple les paramètres qu'il souhaite prendre en compte dans la prédiction. Cela lui permet également de faire varier la ou les valeurs de certaines variables pour voir l'incidence que cela a sur la prédiction et donc sur l'état de dégradation futur de la batterie électrique 10.

Avantageusement, le système électronique 200 peut comprendre un module de contrôle. Ce module de contrôle est de préférence configuré pour contrôler rétroactivement au moins un paramètre de ladite batterie électrique 10. Selon un mode de réalisation, ce module de contrôle peut être un BMS 40.

La présente invention permet ainsi une amélioration des performances d'une batterie électrique par anticipation de son taux de dégradation via la génération d'un modèle mathématique prédictif permettant des prédictions.

L'invention n'est pas limitée aux modes de réalisations précédemment décrits et s'étend à tous les modes de réalisation couverts par les revendications.

Toutes les publications auxquelles il est fait référence dans cette description sont incorporées par renvoi dans leur intégralité à toutes fins d'aide à la compréhension de la présente invention.

### Références numériques

10 Batterie électrique
20 Base de données
30 Ensemble de capteurs
40 Système de gestion de la batterie électrique BMS
50 Boucle rétroactive
60 Graphique de décision
61 Première classe
62 Deuxième classe
63 Troisième classe
64 Quatrième classe
100Procédé de prédiction
110 Première étape de collecte
120 Etape de sélection
130 Deuxième étape de collecte
140 Etape de traitement par apprentissage automatique
141 Etape de calcul
142 Etape de classification
143 Etape de calcul
144 Etape d'obtention d'un modèle mathématique prédictif
200 Système électronique
210 Premier module de collecte
220 Module de sélection
230 Deuxième module de collecte
240 Module de calcul
250Module de communication
260 Interface graphique utilisateur

## Revendications

1. Procédé de prédiction (100) de l'état de dégradation d'au moins une batterie électrique (10) dans un véhicule automobile électrique ou hybride, ledit procédé (100) étant configuré pour être exécuté par au moins un système électronique (200), ledit système électronique étant configuré pour communiquer avec au moins une base de données et/ou au moins un ensemble de capteurs, ledit procédé (100) comprenant:
**a.** Une première étape de collecte (110) d'au moins une information relative à un protocole de cyclage initial, ledit protocole de cyclage initial étant pris parmi au moins la pluralité de protocoles de cyclages suivante :
i. Un premier protocole de cyclage, ledit premier protocole de cyclage étant un protocole de cyclage à courant constant et à tension constante ;
ii. Un deuxième protocole de cyclage, ledit deuxième protocole de cyclage étant un protocole de cyclage à courant pulsé ;
iii. Un troisième protocole de cyclage, ledit troisième protocole de cyclage étant un protocole de cyclage de courant à plusieurs étages ;
**b.** Une étape de sélection (120) d'au moins deux protocoles de cyclage de prédiction pris parmi ladite pluralité de protocoles de cyclage, y incluant le premier protocole et le deuxième protocole de cyclage ;
**c.** Une deuxième étape de collecte (130) d'au moins une donnée relative à au moins un ensemble de paramètres, ledit ensemble de paramètres comprenant au moins l'un des paramètres suivants :
i. Un état de charge initial de la batterie électrique ;
ii. Un état de charge final de la batterie électrique ;
iii. Un nombre N de cycles de charges-décharges de ladite batterie ;
iv. Une température T de la batterie électrique ;
v. Un taux de charge C, c'est-à-dire une vitesse de charge, associé à au moins un protocole de cyclage pris parmi au moins ladite pluralité de protocoles de cyclage ;
**d.** Une étape de traitement (140) par apprentissage automatique à partir d'au moins un modèle mathématique pré-entrainé, de ladite au moins une information, de ladite au moins une donnée et de chaque protocole de cyclage de prédiction sélectionné, ladite étape de traitement comprenant au moins :
i. Une étape de calcul (141) d'au moins un descripteur par application dudit modèle mathématique pré-entrainé dans un espace de calcul multidimensionnel, ledit espace de calcul multidimensionnel étant configuré de sorte que chaque paramètre dudit ensemble de paramètres définisse une dimension dudit espace de calcul multidimensionnel ;
ii. Une étape de classification (142) de l'état de dégradation à partir dudit descripteur relativement à un ensemble de classes prédéterminées ;
iii. Une étape de calcul (143) de l'évolution temporelle dudit état de dégradation de ladite batterie électrique (10), par calcul d'une pluralité d'états de dégradation de ladite batterie électrique, en fonction d'au moins une variable, ladite variable étant prise parmi au moins :
• Un état de charge initial de la batterie électrique (10) ;
• Un état de charge final de la batterie électrique (10) ;
• Une pression appliquée à au moins une partie de la batterie électrique (10) ;
• Un nombre N' de cycles de charges-décharges de ladite batterie électrique (10) ;
• Une température T' de la batterie électrique (10) ;
• Un premier taux de charge C1 relatif au premier protocole de cyclage ;
• Un deuxième taux de charge C2 relatif au deuxième protocole de cyclage ;
• Un troisième taux de charge C3 relatif au troisième protocole de cyclage ;
• Un premier taux de décharge D1 relatif au premier protocole de cyclage ;
• Un deuxième taux de décharge D2 relatif au deuxième protocole de cyclage ;
• Un troisième taux de décharge D3 relatif au troisième protocole de cyclage ;
• Une limite de charge ;
• Un temps de pause à courant nul ;
• Un autre protocole de cyclage ;
iv. Une étape d'obtention (144) d'un état calculé de la dégradation de ladite batterie électrique (10), ledit état calculé comprenant au moins un modèle mathématique prédictif, ledit modèle mathématique prédictif étant configuré pour représenter mathématiquement l'évolution de l'état de dégradation de ladite batterie électrique (10) en fonction au moins de ladite variable,
le procédé comprenant au moins une **étape de contrôle rétroactif,** par au moins un système de gestion (40) de la batterie électrique (10), d'au moins une variable en fonction dudit modèle mathématique prédictif et/ou d'au moins une consigne prédéterminée.

2. Procédé (100) selon la revendication précédente comprenant au moins une étape d'affichage, par au moins un module d'affichage dudit système électronique (200), d'au moins une représentation graphique (60) dudit modèle mathématique prédictif.

3. Procédé (100) selon l'une quelconque des revendications précédentes comprenant au moins une étape d'interaction par un utilisateur avec ledit modèle mathématique prédictif via une interface utilisateur (260) dudit système électronique (200).

4. Procédé (100) selon l'une quelconque des revendications précédentes dans lequel à l'étape de de contrôle rétroactif, le système de gestion (40) de la batterie électrique (10) ajuste des paramètres de charge et de décharge de la batterie.

5. Procédé (100) selon la revendication 4, dans lequel le système de gestion (40) de la batterie électrique (10) sélectionne opérationnellement un protocole de cyclage parmi la pluralité de protocoles de cyclages.

6. Procédé (100) selon la revendication 4, dans lequel le système de gestion (40) de la batterie électrique (10) planifie les calendriers de maintenance de la batterie électrique de la batterie électrique.

7. Procédé (100) selon l'une quelconque des revendications précédentes dans lequel l'étape de contrôle rétroactif est réalisée en temps réel.

8. Procédé (100) selon l'une quelconque des revendications précédentes dans lequel au moins l'une parmi respectivement la première étape de collecte (110) et la deuxième étape de collecte (130) comprend l'acquisition respectivement de ladite information et de ladite donnée à partir d'au moins une base de données (20) et/ou d'au moins un ensemble de capteurs (30).

9. Procédé (100) selon l'une quelconque des revendications précédentes, dans lequel le modèle mathématique prédictif-entrainé a été entrainé sur des données de diverses batteries électriques en utilisant des données de batteries électriques issues de constructeurs, intégrateurs ou utilisateurs.

10. Procédé (100) selon l'une quelconque des revendications précédentes, dans lequel ledit ensemble de paramètres comprend au moins les paramètres suivants :
- un état de charge initial de la batterie électrique ;
- un nombre N de cycles de charges-décharges de ladite batterie ;
- une température T de la batterie électrique ;
- un taux de charge C, c'est-à-dire une vitesse de charge, associé à au moins un protocole de cyclage pris parmi au moins ladite pluralité de protocoles de cyclage.

11. Procédé (100) selon l'une quelconque des revendications précédentes, dans lequel l'étape de sélection (120) d'au moins deux protocoles de cyclage de prédiction, pris parmi la pluralité de protocoles de cyclage, comprend trois protocoles de cyclage à savoir le premier protocole, le deuxième protocole et le troisième protocole de cyclage.

12. Produit programme d'ordinateur, de préférence enregistré sur un support de mémoire non transitoire, comprenant des instructions, qui lorsqu'elles sont effectuées par au moins l'un parmi un processeur, un ordinateur, exécute le procédé (100) selon l'une quelconque des revendications précédentes.

13. Support de mémoire non transitoire comprenant le produit programme d'ordinateur selon la revendication 12.

14. Système électronique (200) configuré pour exécuter le procédé (100) selon l'une quelconque des revendications 1 à 6, ledit système électronique (200) comprenant:
**a.** Un module de communication (250) configuré pour communiquer avec au moins une base de données (20) et/ou au moins un ensemble de capteurs (30) ;
**b.** Un premier module de collecte (210) configuré pour collecter, de préférence via le module de communication (250), une information relative au protocole de cyclage initial de la batterie électrique (10) ;
**c.** Un module de sélection (220) configuré pour sélectionner au moins deux protocoles de cyclage de prédiction parmi une pluralité de protocoles de cyclage, y incluant le premier protocole et le deuxième protocole de cyclage ;
**d.** Un deuxième module de collecte (230) configuré pour collecter, de préférence via le module de communication (250), une donnée relative à un ensemble de paramètres ;
**e.** Un module de calcul (240) configuré pour :
i. Traiter par apprentissage automatique à partir d'au moins un modèle mathématique pré-entrainé, ladite au moins une information, ladite au moins une donnée, pour chaque protocole de cyclage de prédiction sélectionné ;
ii. Calculer au moins un descripteur par application dudit modèle mathématique pré-entrainé dans un espace de calcul multidimensionnel ;
iii. Classifier l'état de dégradation de ladite batterie électrique (10) à partir dudit descripteur relativement à un ensemble de classes prédéterminées ;
iv. Calculer l'évolution temporelle dudit état de dégradation de ladite batterie électrique (10), par calcul d'une pluralité d'états de dégradation de ladite batterie électrique, en fonction d'au moins une variable, ladite variable étant prise parmi au moins :
• Un état de charge initial de la batterie électrique (10) ;
• Un état de charge final de la batterie électrique (10) ;
• Une pression appliquée à au moins une partie de la batterie électrique (10) ;
• Un nombre N' de cycles de charges-décharges de ladite batterie électrique (10) ;
• Une température T' de la batterie électrique (10) ;
• Un premier taux de charge C1 relatif au premier protocole de cyclage ;
• Un deuxième taux de charge C2 relatif au deuxième protocole de cyclage ;
• Un troisième taux de charge C3 relatif au troisième protocole de cyclage ;
• Un premier taux de décharge D1 relatif au premier protocole de cyclage ;
• Un deuxième taux de décharge D2 relatif au deuxième protocole de cyclage ;
• Un troisième taux de décharge D3 relatif au troisième protocole de cyclage ;
• Une limite de charge ;
• Un temps de pause à courant nul ;
• Un autre protocole de cyclage ;
**f.** Générer au moins un modèle mathématique prédictif, ledit modèle mathématique prédictif étant configuré pour représenter mathématiquement l'évolution de l'état de dégradation de ladite batterie électrique (10) en fonction au moins de ladite variable
effectuer au moins une **étape de contrôle rétroactif,** par au moins un système de gestion (40) de la batterie électrique (10), d'au moins une variable en fonction dudit modèle mathématique prédictif et/ou d'au moins une consigne prédéterminée.

15. Système (200) selon la revendication précédente comprenant :
**a.** au moins un module d'affichage configuré pour afficher au moins une représentation graphique dudit modèle mathématique, et
**b.** au moins une interface utilisateur (260) configurée pour permettre au moins une interaction par un utilisateur avec ledit modèle mathématique prédictif.

## Patentansprüche

1. Verfahren zum Vorhersagen (100) des Degradationszustands mindestens einer elektrischen Batterie (10) in einem elektrischen oder hybriden Kraftfahrzeug, wobei das Verfahren (100) konfiguriert ist, um durch mindestens ein elektronisches System (200) ausgeführt zu werden, wobei das elektronische System zum Kommunizieren mit mindestens einer Datenbank und/oder mindestens einem Satz von Sensoren konfiguriert ist, das Verfahren (100) umfassend:
a. einen ersten Schritt des Sammelns (110) von mindestens einer Information bezüglich eines anfänglichen Zyklenprotokolls, wobei das anfängliche Zyklenprotokoll aus mindestens der folgenden Vielzahl von Zyklenprotokollen genommen wird:
i. einem ersten Zyklenprotokoll, wobei das erste Zyklenprotokoll ein Zyklenprotokoll mit konstantem Strom und konstanter Spannung ist;
ii. einem zweiten Zyklenprotokoll, wobei das zweite Zyklenprotokoll ein Zyklenprotokoll mit gepulstem Strom ist;
iii. einem dritten Zyklenprotokoll, wobei das dritte Zyklenprotokoll ein mehrstufiges Stromzyklenprotokoll ist;
b. einen Schritt des Auswählens (120) von mindestens zwei Zyklenvorhersageprotokollen, die aus der Vielzahl von Zyklenprotokollen genommen werden, darin eingeschlossen das erste Protokoll und das zweite Zyklenprotokoll;
c. einen zweiten Schritt des Sammelns (130) von mindestens einer Angabe bezüglich mindestens eines Satzes von Parametern, der Satz von Parametern umfassend mindestens einen der folgenden Parameter:
i. einen anfänglichen Ladezustand der elektrischen Batterie;
ii. einen Endladezustand der elektrischen Batterie;
iii. eine Anzahl N von Lade-Entlade-Zyklen der Batterie;
iv. eine Temperatur T der elektrischen Batterie;
v. eine Laderate C, das heißt eine Ladegeschwindigkeit, die mindestens einem Zyklenprotokoll, das aus mindestens der Vielzahl von Zyklenprotokollen genommen wird, zugeordnet ist;
d. einen Schritt des Verarbeitens (140) durch maschinelles Lernen anhand von mindestens einem vortrainierten mathematischen Modell, von der mindestens einen Information, von der mindestens einen Angabe und von jedem ausgewählten Zyklenvorhersageprotokoll, der Schritt des Verarbeitens mindestens umfassend:
i. einen Schritt des Berechnens (141) von mindestens einem Deskriptor durch Anwendung des vortrainierten mathematischen Modells in einem multidimensionalen Berechnungsraum, wobei der multidimensionale Berechnungsraum konfiguriert ist, sodass jeder Parameter des Satzes von Parametern eine Dimension des multidimensionalen Berechnungsraums definiert;
ii. einen Schritt des Klassifizierens (142) des Degradationszustands aus dem Deskriptor in Bezug auf einen Satz von vorbestimmten Klassen;
iii. einen Schritt des Berechnens (143) der zeitlichen Entwicklung des Degradationszustands der elektrischen Batterie (10), durch Berechnung einer Vielzahl von Degradationszuständen der elektrischen Batterie, in Abhängigkeit von mindestens einer Variablen, wobei die Variable aus mindestens folgenden genommen wird:
• einem anfänglichen Ladezustand der elektrischen Batterie (10);
• einem Endladezustand der elektrischen Batterie (10);
• einem auf mindestens einen Teil der elektrischen Batterie (10) ausgeübten Druck;
• einer Anzahl N' von Lade-Entlade-Zyklen der elektrischen Batterie (10);
• einer Temperatur T' der elektrischen Batterie (10);
• einer ersten Laderate C1 bezüglich des ersten Zyklenprotokolls;
• einer zweiten Laderate C2 bezüglich des zweiten Zyklenprotokolls;
• einer dritten Laderate C3 bezüglich des dritten Zyklenprotokolls;
• einer ersten Entladerate D1 bezüglich des ersten Zyklenprotokolls;
• einer zweiten Entladerate D2 bezüglich des zweiten Zyklenprotokolls;
• einer dritten Entladerate D3 bezüglich des dritten Zyklenprotokolls;
• einer Ladegrenze;
• einer Pausenzeit bei Nullstrom;
• einem anderen Zyklenprotokoll;
iv. einen Schritt des Erhaltens (144) eines berechneten Degradationszustands der elektrischen Batterie (10), der berechnete Zustand umfassend mindestens ein mathematisches Vorhersagemodell, wobei das mathematische Vorhersagemodell zum mathematischen Darstellen des Degradationszustands der elektrischen Batterie (10) in Abhängigkeit von mindestens der Variablen konfiguriert ist, das Verfahren umfassend mindestens einen **Schritt der rückwirkenden Kontrolle** durch mindestens ein Verwaltungssystem (40) der elektrischen Batterie (10) von mindestens einer Variablen in Abhängigkeit von dem mathematischen Vorhersagemodell und/oder von mindestens einer vorbestimmten Sollvorgabe.

2. Verfahren (100) nach dem vorstehenden Anspruch, umfassend mindestens einen Schritt der Anzeige, durch mindestens ein Anzeigemodul des elektronischen Systems (200), mindestens einer grafischen Darstellung (60) des mathematischen Vorhersagemodells.

3. Verfahren (100) nach einem der vorstehenden Ansprüche, umfassend mindestens einen Schritt der Interaktion durch einen Benutzer mit dem mathematischen Vorhersagemodell über eine Benutzerschnittstelle (260) des elektronischen Systems (200).

4. Verfahren (100) nach einem der vorstehenden Ansprüche, wobei in dem Schritt der rückwirkenden Kontrolle das Verwaltungssystem (40) der elektrischen Batterie (10) Lade- und Entladeparameter der Batterie anpasst.

5. Verfahren (100) nach Anspruch 4, wobei das Verwaltungssystem (40) der elektrischen Batterie (10) betriebsmäßig ein Zyklenprotokoll aus der Vielzahl von Zyklenprotokollen auswählt.

6. Verfahren (100) nach Anspruch 4, wobei das Verwaltungssystem (40) der elektrischen Batterie (10) die Wartungspläne der elektrischen Batterie plant.

7. Verfahren (100) nach einem der vorstehenden Ansprüche, wobei der Schritt der rückwirkenden Kontrolle in Echtzeit durchgeführt wird.

8. Verfahren (100) nach einem der vorstehenden Ansprüche, wobei mindestens einer von dem ersten Schritt des Sammelns (110) beziehungsweise dem zweiten Schritt des Sammelns (130) die Erfassung der Information beziehungsweise der Angabe aus mindestens einer Datenbank (20) und/oder aus mindestens einem Satz von Sensoren (30) umfasst.

9. Verfahren (100) nach einem der vorstehenden Ansprüche, wobei das trainierte mathematische Vorhersagemodell auf Daten von diversen elektrischen Batterien unter Verwendung von Daten von elektrischen Batterien, die von Herstellern, Integratoren oder Benutzern stammen, trainiert wurde.

10. Verfahren (100) nach einem der vorstehenden Ansprüche, wobei der Satz von Parametern mindestens die folgenden Parameter umfasst:
- einen anfänglichen Ladezustand der elektrischen Batterie;
- eine Anzahl N von Lade-Entlade-Zyklen der Batterie;
- eine Temperatur T der elektrischen Batterie;
- eine Laderate C, das heißt eine Ladegeschwindigkeit, die mindestens einem Zyklenprotokoll, das aus mindestens der Vielzahl von Zyklenprotokollen genommen wird, zugeordnet ist.

11. Verfahren (100) nach einem der vorstehenden Ansprüche, wobei der Schritt der Auswahl (120) von mindestens zwei Zyklenvorhersageprotokollen, die aus der Vielzahl von Zyklenprotokollen genommen werden, drei Zyklenprotokolle umfasst, nämlich das erste Protokoll, das zweite Protokoll und das dritte Zyklenprotokoll.

12. Computerprogrammprodukt, vorzugsweise auf einem nichtflüchtigen Speicherträger gespeichert, umfassend Anweisungen, die, wenn sie durch mindestens einem von einem Prozessor, einem Computer durchgeführt werden, das Verfahren (100) nach einem der vorstehenden Ansprüche ausführen.

13. Nichtflüchtiger Speicherträger, umfassend das Computerprogrammprodukt nach Anspruch 12.

14. Elektronisches System (200), das zum Ausführen des Verfahrens (100) nach einem der Ansprüche 1 bis 6 konfiguriert ist, das elektronische System (200) umfassend:
a. ein Kommunikationsmodul (250), das zum Kommunizieren mit mindestens einer Datenbank (20) und/oder mindestens einem Satz von Sensoren (30) konfiguriert ist;
b. ein erstes Sammelmodul (210), das zum Sammeln, vorzugsweise über das Kommunikationsmodul (250), einer Information bezüglich des anfänglichen Zyklenprotokolls der elektrischen Batterie (10) konfiguriert ist;
c. ein Auswahlmodul (220), das zum Auswählen von mindestens zwei Zyklenvorhersageprotokollen aus einer Vielzahl von Zyklenprotokollen auszuwählen, darin eingeschlossen das erste Protokoll und das zweite Zyklenprotokoll;
d. ein zweites Sammelmodul (230), das zum Sammeln, vorzugsweise über das Kommunikationsmodul (250), einer Angabe bezüglich eines Satzes von Parametern zu konfiguriert ist;
e. ein Berechnungsmodul (240), das konfiguriert ist zum:
i. Verarbeiten, mittels maschinellen Lernens anhand von mindestens einem vortrainierten mathematischen Modell, der mindestens einen Information, der mindestens einen Angabe, für jedes ausgewählte Zyklenvorhersageprotokoll;
ii. Berechnen mindestens eines Deskriptors durch Anwendung des vortrainierten mathematischen Modells in einem multidimensionalen Berechnungsraum;
iii. Klassifizieren des Degradationszustands der elektrischen Batterie (10) anhand des Deskriptors in Bezug auf einen Satz von vorbestimmten Klassen;
iv. Berechnen der zeitlichen Entwicklung des Degradationszustands der elektrischen Batterie (10), durch Berechnung einer Vielzahl von Degradationszuständen der elektrischen Batterie, in Abhängigkeit von mindestens einer Variablen, wobei die Variable aus mindestens folgenden genommen wird:
• einem anfänglichen Ladezustand der elektrischen Batterie (10);
• einem Endladezustand der elektrischen Batterie (10);
• einem auf mindestens einen Teil der elektrischen Batterie (10) ausgeübten Druck;
• einer Anzahl N' von Lade-Entlade-Zyklen der elektrischen Batterie (10);
• einer Temperatur T' der elektrischen Batterie (10);
• einer ersten Laderate C1 bezüglich des ersten Zyklenprotokolls;
• einer zweiten Laderate C2 bezüglich des zweiten Zyklenprotokolls;
• einer dritten Laderate C3 bezüglich des dritten Zyklenprotokolls;
• einer ersten Entladerate D1 bezüglich des ersten Zyklenprotokolls;
• einer zweiten Entladerate D2 bezüglich des zweiten Zyklenprotokolls;
• einer dritten Entladerate D3 bezüglich des dritten Zyklenprotokolls;
• einer Ladegrenze;
• einer Pausenzeit bei Nullstrom;
• einem anderen Zyklenprotokoll;
f. Generieren von mindestens einem mathematischen Vorhersagemodell, wobei das mathematische Vorhersagemodell zum Darstellen der mathematischen Entwicklung des Degradationszustands der elektrischen Batterie (10), in Abhängigkeit von mindestens der Variablen, konfiguriert ist.
Durchführen von mindestens einem **Schritt der rückwirkenden Kontrolle** durch mindestens ein Verwaltungssystem (40) der elektrischen Batterie (10) von mindestens einer Variablen in Abhängigkeit von dem mathematischen Vorhersagemodell und/oder mindestens einer vorbestimmten Sollvorgabe.

15. System (200) nach dem vorstehenden Anspruch, umfassend:
a. mindestens ein Anzeigemodul, das zum Anzeigen von mindestens einer grafischen Darstellung des mathematischen Modells konfiguriert ist, und
b. mindestens eine Benutzerschnittstelle (260), die zum Ermöglichen von mindestens einer Interaktion durch einen Benutzer mit dem mathematischen Vorhersagemodell konfiguriert ist.

## Claims

1. Method (100) for predicting the degradation state of at least one electric battery (10) in an electric or hybrid motor vehicle, said method (100) being configured to be executed by at least one electronic system (200), said electronic system being configured to communicate with at least one database and/or at least one set of sensors, said method (100) comprising:
a. a first collection step (110) of collecting at least one piece of information relating to an initial cycling protocol, said initial cycling protocol being taken from at least the following plurality of cycling protocols:
i. a first cycling protocol, said first cycling protocol being a constant current-constant voltage cycling protocol;
ii. a second cycling protocol, said second cycling protocol being a pulsed current cycling protocol;
iii. a third cycling protocol, said third cycling protocol being a multi-step current cycling protocol;
b. a step (120) of selecting at least two prediction cycling protocols taken from said plurality of cycling protocols, including the first cycling protocol and the second cycling protocol;
c. a second collection step (130) of collecting at least one datum relating to at least one set of parameters, said set of parameters comprising at least one of the following parameters:
i. an initial state of charge of the electric battery;
ii. a final state of charge of the electric battery;
iii. a number N of charge-discharge cycles of said battery;
iv. a temperature T of the electric battery;
v. a charge rate C, i.e., a charge speed, associated with at least one cycling protocol taken from at least said plurality of cycling protocols;
d. a step (140) of processing, by machine learning based on at least one pre-trained mathematical model, said at least one piece of information, said at least one datum, and each selected prediction cycling protocol, said processing step comprising at least:
i. a step (141) of calculating at least one descriptor by applying said pre-trained mathematical model in a multidimensional calculation space, said multidimensional calculation space being configured such that each parameter of said set of parameters defines a dimension of said multidimensional calculation space;
ii. a step (142) of classifying the degradation state on the basis of said descriptor relative to a set of predetermined classes;
iii. a step (143) of calculating the temporal evolution of said degradation state of said electric battery (10), by calculating a plurality of degradation states of said electric battery, as a function of at least one variable, said variable being taken from at least:
• an initial state of charge of the electric battery (10);
• a final state of charge of the electric battery (10);
• a pressure applied to at least one part of the electric battery (10);
• a number N' of charge-discharge cycles of said electric battery (10);
• a temperature T' of the electric battery (10);
• a first charge rate C1 relating to the first cycling protocol;
• a second charge rate C2 relating to the second cycling protocol;
• a third charge rate C3 relating to the third cycling protocol;
• a first discharge rate D1 relating to the first cycling protocol;
• a second discharge rate D2 relating to the second cycling protocol;
• a third discharge rate D3 relating to the third cycling protocol;
• a charge limit;
• a zero-current pause time;
• another cycling protocol;
iv. a step (144) of obtaining a calculated state of the degradation of said electric battery (10), said calculated state comprising at least one predictive mathematical model, said predictive mathematical model being configured to mathematically represent the evolution of the degradation state of said electric battery (10) as a function of at least said variable, the method comprising at least one step of at least one management system (40) for the electric battery (10) **feedback controlling** at least one variable as a function of said predictive mathematical model and/or at least one predetermined setpoint.

2. Method (100) according to the preceding claim, comprising at least one step of at least one display module of said electronic system (200) displaying at least one graphical representation (60) of said predictive mathematical model.

3. Method (100) according to either of the preceding claims, comprising at least one step of a user interacting with said predictive mathematical model via a user interface (260) of said electronic system (200).

4. Method (100) according to any of the preceding claims, wherein in the feedback control step, the management system (40) for the electric battery (10) adjusts charge and discharge parameters of the battery.

5. Method (100) according to claim 4, wherein the management system (40) for the electric battery (10) operationally selects a cycling protocol from the plurality of cycling protocols.

6. Method (100) according to claim 4, wherein the management system (40) for the electric battery (10) plans the maintenance schedules of the electric battery.

7. Method (100) according to any of the preceding claims, wherein the feedback control step is performed in real time.

8. Method (100) according to any of the preceding claims, wherein at least one of the first collection step (110) and the second collection step (130) comprises respectively acquiring said piece of information and said datum from at least one database (20) and/or at least one set of sensors (30).

9. Method (100) according to any of the preceding claims, wherein the predictive-trained mathematical model has been trained on data from various electric batteries using electric battery data from manufacturers, integrators, or users.

10. Method (100) according to any of the preceding claims, wherein said set of parameters comprises at least the following parameters:
- an initial state of charge of the electric battery;
- a number N of charge-discharge cycles of said battery;
- a temperature T of the electric battery;
- a charge rate C, i.e., a charge speed, associated with at least one cycling protocol taken from at least said plurality of cycling protocols.

11. Method (100) according to any of the preceding claims, wherein the step (120) of selecting at least two prediction cycling protocols taken from the plurality of cycling protocols comprises three cycling protocols, namely the first cycling protocol, the second cycling protocol, and the third cycling protocol.

12. Computer program product, preferably stored on a non-transitory memory medium, comprising instructions, which, when the instructions are performed by at least one from a processor and a computer, executes the method (100) according to any of the preceding claims.

13. Non-transitory memory medium comprising the computer program product according to claim 12.

14. Electronic system (200) configured to execute the method (100) according to any of claims 1 to 6, said electronic system (200) comprising:
a. a communication module (250) configured to communicate with at least one database (20) and/or at least one set (30) of sensors;
b. a first collection module (210) configured to collect, preferably via the communication module (250), a piece of information relating to the initial cycling protocol of the electric battery (10);
c. a selection module (220) configured to select at least two prediction cycling protocols from a plurality of cycling protocols, including the first cycling protocol and the second cycling protocol;
d. a second collection module (230) configured to collect, preferably via the communication module (250), a datum relating to a set of parameters;
e. a calculation module (240) configured to:
i. process, by machine learning based on at least one pre-trained mathematical model, said at least one piece of information and said at least one datum for each selected prediction cycling protocol;
ii. calculate at least one descriptor by applying said pre-trained mathematical model in a multidimensional calculation space;
iii. classify the degradation state of said electric battery (10) on the basis of said descriptor relative to a set of predetermined classes;
iv. calculate the temporal evolution of said degradation state of said electric battery (10), by calculating a plurality of degradation states of said electric battery, as a function of at least one variable, said variable being taken from at least:
• an initial state of charge of the electric battery (10);
• a final state of charge of the electric battery (10);
• a pressure applied to at least one part of the electric battery (10);
• a number N' of charge-discharge cycles of said electric battery (10);
• a temperature T' of the electric battery (10);
• a first charge rate C1 relating to the first cycling protocol;
• a second charge rate C2 relating to the second cycling protocol;
• a third charge rate C3 relating to the third cycling protocol;
• a first discharge rate D1 relating to the first cycling protocol;
• a second discharge rate D2 relating to the second cycling protocol;
• a third discharge rate D3 relating to the third cycling protocol;
• a charge limit;
• a zero-current pause time;
• another cycling protocol;
f. generate at least one predictive mathematical model, said predictive mathematical model being configured to mathematically represent the evolution of the degradation state of said electric battery (10) as a function of at least said variable; and
perform at least one step of at least one management system (40) for the electric battery (10) **feedback controlling** at least one variable as a function of said predictive mathematical model and/or at least one predetermined setpoint.

15. System (200) according to the preceding claim, comprising:
a. at least one display module configured to display at least one graphical representation of said mathematical model, and
b. at least one user interface (260) configured to allow a user to interact with said predictive mathematical model at least once.
